# EUROPÄISCHE PATENTSCHRIFT

(11) **EP 0 567 008 B1**
(45) Veröffentlichungstag und Bekanntmachung des Hinweises auf die Patenterteilung: **06.10.1999**
(21) Anmeldenummer: 93106208.7
(22) Anmeldetag: 16.04.1993
(51) Int. Cl.: C30B 15/02

(54) **Verfahren zur Züchtung mehrerer Einkristalle und Vorrichtung zu dessen Anwendung**
Process to grow several single crystal and apparatus therefor
Procédé et appareillage pour la croissance de plusieurs monocristaux

(30) Priorität: 24.04.1992 US 873375
(43) Veröffentlichungstag der Anmeldung: 27.10.1993
(73) Patentinhaber: MEMC Electronic Materials, Inc., St. Peters, Missouri 63376 (US)
(72) Erfinder: Holder, John D., MEMC ELECTRONIC MATERIALS, Inc., St. Peters, Missouri 63376 (US)
(74) Vertreter: Maiwald, Walter, Dr. Dipl.-Chem.

(56) Entgegenhaltungen:
- DE-A- 3 036 178
- US-A- 4 036 595
- US-A- 4 134 785
- US-A- 4 410 494
- PATENT ABSTRACTS OF JAPAN vol. 9, no. 317 (C-319) (2040) 12. Dezember 1985 & JP-A-60 151 295 (TOSHIBA K.K.) 9. August 1985

## Beschreibung

### Hintergrund der Erfindung

Gegenstand der vorliegenden Erfindung ist im allgemeinen das Verfahren und die Vorrichtung zur Züchtung eines Einkristalls und im besonderen das Verfahren zur Züchtung mehrerer Kristalle und die für dieses Verfahren benötigte Vorrichtung.

Der größte Teil des polykristallinen Siliciums, das zur Herstellung von Siliciumchips für den Einsatz in der Festkörper-Elektronikindustrie verwendet wird, wird nach dem Czochralski-Verfahren gefertigt. Kurz gesagt werden bei diesem Verfahren zur Herstellung einer Siliciumschmelze Klumpen von hochreinem polykristallinem Silicium in einem Schmelztiegel aus Quarz geschmolzen, der in einen speziell hierfür konzipierten Ofen gestellt wird. Üblicherweise läßt man ein inertes Gas, wie beispielsweise Argon, durch den Ofen strömen. Ein relativ kleiner Kristallkeim wird oberhalb des Schmelztiegels auf einen Drahtzug gegeben, mit dem der Kristallkeim nach oben oder unten bewegt werden kann. Der Schmelztiegel wird in eine Drehbewegung versetzt und der Kristallkeim heruntergelassen, bis er das geschmolzene Silicium im Tiegel berührt. Wenn der Keimkristall zu schmelzen beginnt, wird er langsam vom geschmolzenen Silicium zurückgezogen und wächst nun weiter, indem er der Schmelze Silicium entzieht.

Um die Produktionsrate für Einkristalle aus einem Ofen zu erhöhen, ist es wünschenswert, mehr als einen Kristall aus der Siliciumschmelze im Schmelztiegel zu züchten, bevor der Tiegel durch einen neuen mit einer frischen Silicium-Charge ersetzt wird. Das Ersetzen des Tiegels ist ein zeitraubender Vorgang, der die Produktionsrate für Kristalle erheblich verlangsamt. Es ist zwar möglich, der Schmelze geschmolzenes Silicium zuzusetzen, nachdem der Kristall gezüchtet wurde oder auch während des Züchtungsvorgangs, jedoch wird die Zahl der Kristalle, die aus der Schmelze gewonnen werden kann, noch durch den Gehalt der Schmelze an Verunreinigungen, wie z.B. Fe und C, begrenzt. Der Gehalt der Schmelze an Fe, C und anderen Verunreinigungen liegt zunächst im Mikro- oder Nano-Konzentrationsbereich, was erforderlich ist, um Kristalle von ausreichender Reinheit züchten zu können. Die Verunreinigungen weisen unterschiedliche Affinitäten dafür auf, ob sie nun während des Züchtungsvorgangs flüssig bleiben oder im Kristall in eine feste Zustandsform übergehen. Diese Affinität läßt sich numerisch durch den Segregationskoeffizienten der betreffenden Verunreinigung darstellen. Liegt der Segregationskoeffizient unter Eins, so bleibt die Verunreinigung im allgemeinen in der Flüssigkeit zurück, während ihr der Kristallkeim das Silicium entzieht. Beispielsweise hat C einen Koeffizienten von 0,01 und Fe einen Koeffizienten von 8 x 10⁻⁶. Aus diesem Grunde können die Konzentrationen der Verunreinigungen sehr rasch inakzeptable Werte erreichen, selbst wenn der Schmelze ständig neues Silicium zugesetzt wird, und so muß der Schmelztiegel durch einen neuen Tiegel mit einer frischen Charge geschmolzenen Siliciums ersetzt werden.

Aus dem US-Patent 4,134,785 ist ein Verfahren zur Züchtung mehrerer, vornehmlich dotierter Einkristalle bekannt, bei dem zur Ermittlung der Zusammensetzung der Schmelze dieser eine Probemenge entnommen wird und der Schmelze basierend auf den ermittelten Werten hochreines Ausgangsmaterial und/oder Dotierstoff zugesetzt wird.

### Zusammenfassung der Erfindung

Zu den verschiedenen Zielen und Merkmalen der vorliegenden Erfindung gehört die Bereitstellung eines Verfahrens zur Züchtung von Einkristallen gemäß Anspruch 1, bei welchem eine Vielzahl von Kristallen aus einer wiederaufgefüllten Charge von geschmolzenem Ausgangsmaterial gezüchtet wird, wobei die Reinheit den Spezifikationen entspricht; die Bereitstellung eines Verfahrens, das eine Verunreinigung der Charge von geschmolzenem Ausgangsmaterial während des Reinigungsvorgangs verhindert; die Bereitstellung eines Verfahrens, bei dem die Reinigung rasch erfolgen kann, damit ein neuer Züchtungsvorgang eingeleitet werden kann; und die Bereitstellung eines Verfahrens, das einfach in der Handhabung ist.

Weiterhin gehören zu den verschiedenen Zielen und Merkmalen der vorliegenden Erfindung die Bereitstellung einer Vorrichtung gemäß Anspruch 9 zur Erreichung der genannten Verfahrensziele und die Bereitstellung einer Vorrichtung, mit der die genaue Menge der für die Reinigung benötigten Schmelze entnommen werden kann.

Das Verfahren gemäß vorliegender Erfindung zur Züchtung einer Vielzahl von hochreinen Einkristallen aus einer wiederaufgefüllten Schmelze durch Aufrechterhaltung der Reinheit des geschmolzenen Ausgangsmaterials in der Schmelze, die sich in einem Schmelztiegel und dieser in einem Ofen befindet, wie er zur Züchtung hochreiner Einkristalle verwendet wird, umfaßt die folgenden Schritte: Züchtung von mindestens einem Kristall aus dem in dem Tiegel befindlichen Ausgangsmaterial; Herausziehen einer Teilmenge des in dem Tiegel zurückbleibenden Schmelzgutes; Zusetzen von hochreinem Ausgangsmaterial zu der Schmelze und Züchtung von mindestens einem weiteren Einkristall.

Die Vorrichtung zum Herausziehen des Siliciums, deren Aufbau den Anforderungen der vorliegenden Erfindung entspricht, ist dem erfindungsgemäßen Verfahren angepaßt. Sie besteht aus einem Behälter mit einem geeigneten Fassungsvermögen, um das geschmolzene Ausgangsmaterial aufnehmen zu können. Thermisch isolierende Mittel dienen zur Wärmeisolation des Behältervolumens, eine Zuleitung steht mit dem Behälter in Verbindung, um das geschmolzene Ausgangsmaterial in den Behälter zu befördern. Weitere Mittel ziehen das geschmolzene Ausgangsmaterial in den Behälter.

Die Erfindung wird nachfolgend anhand der Zeichnungen erläutert.

### Kurzbeschreibung der Zeichnungen

Fig. 1 zeigt einen schematischen Teil-Querschnitt eines Ofens zur Herstellung von Einkristallen, wobei die zur Aufrechterhaltung der Reinheit des geschmolzenen Ausgangsmaterials im Ofen verwendete Vorrichtung zu sehen ist;
Fig. 2(a)-(c) zeigen in schematischer Weise die Schritte des Herausziehens einer Teilmenge des geschmolzenen Ausgangsmaterials;
Fig. 3 zeigt einen schematischen Längsschnitt durch den Behälter der Vorrichtung;
Fig. 4 zeigt die schematische Schnittaufnahme eines Behälters einer zweiten Ausführungsform;

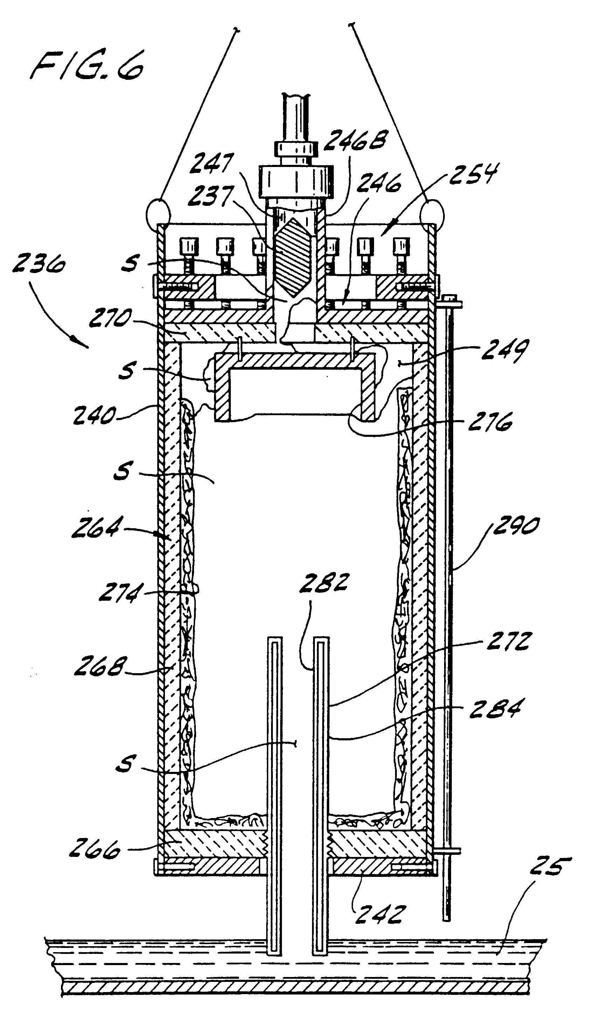

Fig. 5 zeigt die Schnittaufnahme eines röhrenförmigen Teils in einer Ebene entlang der Linie 5-5 von Fig. 3;
Fig. 6 zeigt einen schematischen Längsschnitt eines Behälters in einer dritten Ausführungsform;
In den Fig. 7(a)-(b) sind Kurven der Konzentration der Verunreinigung C in den Kristallen dargestellt, die einerseits ohne Anwendung des Verfahrens gemäß vorliegender Erfindung und andererseits unter Einsatz des Verfahrens gemäß vorliegender Erfindung aufgetreten ist;
In den Fig. 8(a)-(b) sind Kurven der Konzentration der Verunreinigung Fe in den Kristallen dargestellt, die einerseits ohne Verwendung des Verfahrens gemäß vorliegender Erfindung und andererseits unter Einsatz des Verfahrens gemäß vorliegender Erfindung entstanden ist; und
Fig. 9(a)-(b) zeigen Kurven zur Lebensdauer des Halbleitermaterials, das entweder ohne Anwendung des Verfahrens gemäß vorliegender Erfindung oder unter Einsatz des Verfahrens gemäß vorliegender Erfindung hergestellt wurde.

Die jeweiligen Bezugszeichen im Text verweisen auf die dazugehörigen Bauteile in den verschiedenen Ansichten der Zeichnungen.

### Detaillierte Beschreibung der bevorzugten Ausführungsart

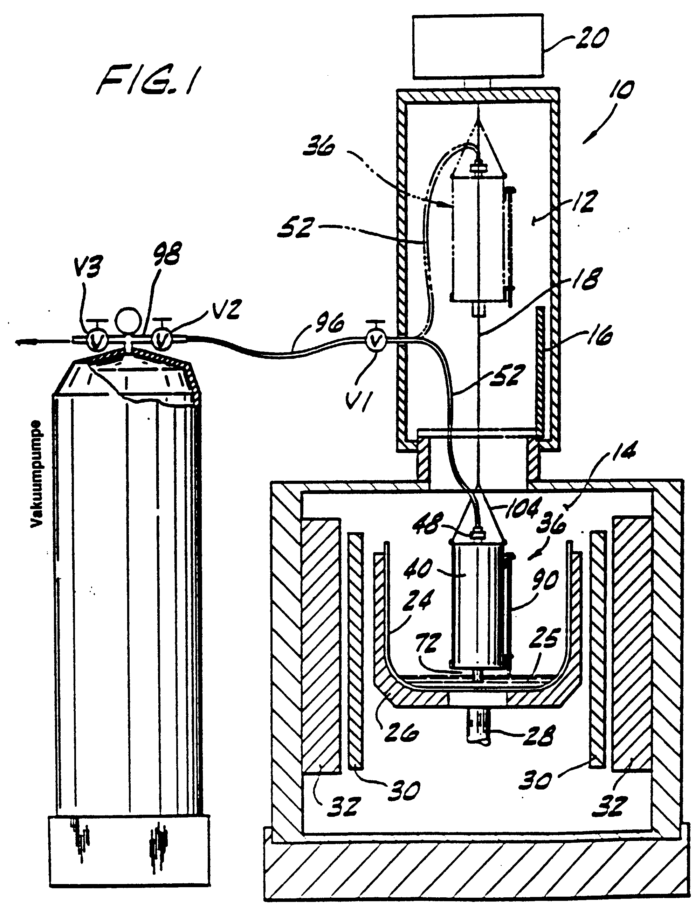

In den Zeichnungen, insbesondere der Fig. 1, ist ein Ofen 10 zu sehen, welcher von der Art ist, wie sie auch zur Züchtung von monokristallinen Silicium-Blöcken verwendet wird, und der eine Ziehkammer 12 und eine Kristall-Züchtungskammer 14 enthält. Ein Absperrventil oder eine Sicherheitsklappe 16 ist zwischen der Ziehkammer 12 und der Kristall-Züchtungskammer 14 auf dem Ofen drehbar angelenkt, um zwischen einer Öffnungsstellung (plastische Darstellung in Fig. 1), bei der die Ziehkammer und die Kristall-Züchtungskammer miteinander in Verbindung stehen, und einer geschlossenen Stellung (siehe Phantombild in Fig. 1) wählen zu können, bei der die Ziehkammer und die Kristall-Züchtungskammer voneinander getrennt sind. Ein Drahtzug 18 hängt von einem Kristall-Hebemechanismus 20 herab, der wie eine Seilwinde funktioniert und den Drahtzug bei Bedarf auf- oder abspult. Während des Kristall-Züchtungsvorgangs wird ein Kristallkeim (nicht abgebildet) am unteren Ende des Drahtzugs festgehalten.

Ein Schmelztiegel 24 in der Kristall-Züchtungskammer 14, der geschmolzenes Kristall-Ausgangsmaterial (in der abgebildeten Ausführung: hochreines Silicium) enthält, befindet sich auf einer becherförmigen Drehscheibe 26, die auf einer von der Drehscheibe ausgehenden und mit einem Motor (nicht abgebildet) verbundenen Welle 28 rotieren kann. Ein Graphitheizgerät und eine Wärmeschutzvorrichtung, die dem Schmelztiegel und der Drehscheibe in der Kristall-Züchtungskammer 14 benachbart sind, sind als 30 bzw. 32 schematisch dargestellt. Durch eine Abdeckplatte (nicht abgebildet) im Ofen 10 hat man Zugang zu der Ziehkammer 12, um im Anschluß an den Züchtungsvorgang die Silicium-Blöcke herausnehmen zu können und die nachstehend beschriebene Vorrichtung hineinstellen und herausnehmen zu können.

Der Ofen 10 ist von der Art, wie er bereits zur Verwendung bei der Züchtung von Einkristall-Siliciumkristallen nach dem Czochralski-Verfahren bekannt ist. Bei diesem Verfahren werden zur Herstellung der Siliciumschmelze 25 Klumpen von polykristallinem Silicium im Schmelztiegel 24 im Ofen 10 geschmolzen. Der Ofen 10 wird im Inneren evakuiert, woraufhin man üblicherweise ein Inertgas, wie beispielsweise Argon, durch den Ofen strömen läßt. Nun wird ein verhältnismäßig kleiner Kristallkeim (nicht abgebildet) mit Hilfe eines Keimhalters (nicht abgebildet) oberhalb des Schmelztiegels 24 auf dem Drahtzug 18 angebracht, der an den Kristall-Hebemechanismus 20 angeschlossen ist, welcher den Kristallkeim heben oder senken kann. Anschließend läßt man den Schmelztiegel 24 rotieren und senkt den Kristallkeim soweit, bis er mit der Siliciumschmelze 25 in dem Schmelztiegel in Berührung kommt. Wenn der Keim zu schmelzen beginnt, wird er langsam aus dem geschmolzenen Silicium zurückgezogen, woraufhin er durch Verfestigung des Siliciums aus der Schmelze 25 zu wachsen beginnt.

Um die Effizienz verbessern und die Produktionsrate für Kristalle im Ofen 10 steigern zu können, wird gemäß dem Stand der Technik der Vorrat an geschmolzenem Silicium in dem Schmelztiegel wieder aufgefüllt, damit ein neuer Kristall gezüchtet werden kann, ohne daß der Schmelztiegel 24 und die Siliciumschmelze 25 vorher ersetzt werden müssen. Dies erfolgt durch Zusatz von neuem geschmolzenem Silicium zu der Schmelze 25 im Anschluß an den Kristall-Züchtungsvorgang ("Chargenweises Nachfüllen gemäß Czochralski") oder durch kontinuierlichen Zusatz von geschmolzenem Silicium zu der vorhandenen Schmelze ("Kontinuierliches Nachfüllen gemäß Czochralski"). Die Zahl der Kristalle, die gezüchtet werden kann, bevor das geschmolzene Silicium im Schmelztiegel zu stark verunreinigt wird, ist jedoch beschränkt, weil viele Verunreinigungen in dem geschmolzenen Silicium einen niedrigen Ausscheidungskoeffizienten aufweisen. Normalerweise ist nach Züchtung eines zweiten Kristalls aus der wiederaufgefüllten Siliciumschmelze 25 der Gehalt an Verunreinigungen zu hoch, um einen weiteren Kristall von ausreichend hoher Qualität für den Einsatz in Halbleiter-Anwendungen zu erhalten.

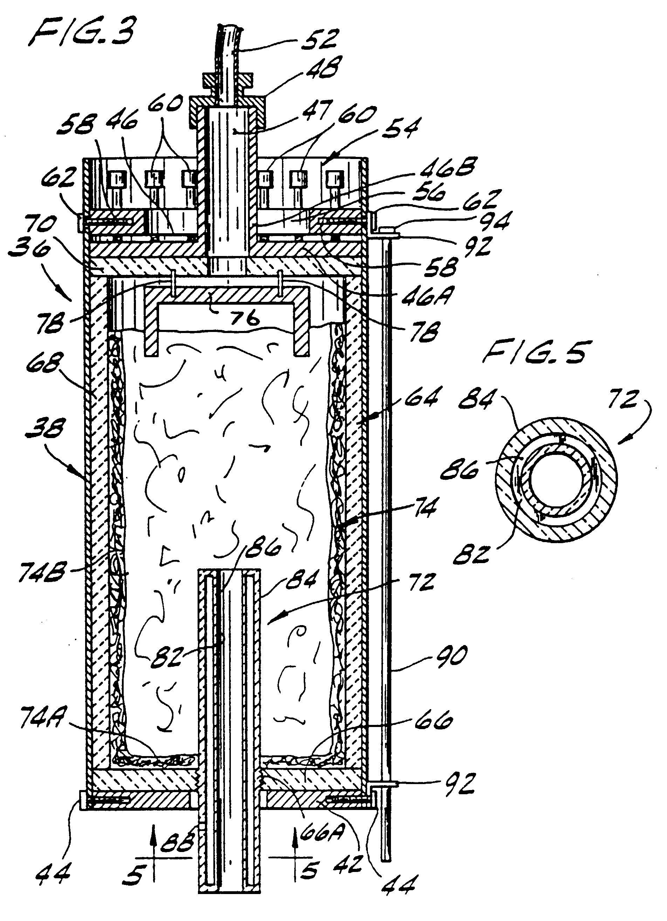

Weiterhin ist in Fig. 1 eine erfindungsgemäße Vorrichtung zur Verwendung im Kristall-Züchtungsverfahren zu sehen, mit der die Reinheit der Siliciumschmelze 25 aufrechterhalten wird. Diese Vorrichtung besteht aus einem Behälter 36 mit einem Fassungsvermögen, das die Aufnahme einer ausreichenden Menge von geschmolzenem Silicium aus der Schmelze 25 ermöglicht. Die Vorrichtung, welche später noch näher beschrieben wird, ist erforderlich, um einen Teil des geschmolzenen Siliciums im Schmelztiegel 24 nach jedem Kristall-Züchtungsvorgang zu entnehmen. Eine erste Ausführungsform des Behälters 36, der in Fig. 3 dargestellt ist, besteht aus einem Gehäuse 38 aus Pulvermetallurgie-Molybdän, einem schwer schmelzbaren Metall. Das Gehäuse 38 besteht aus einem zylindrischen Körper 40 und einer generell kreisförmigen Grundplatte 42, die mit Molybdän-Bolzen 44 am Körper befestigt ist. Eine Abschlußkappe 46 besteht generell aus einem flachen, ringförmigen Teil 46A und einem röhrenförmigen Teil 46B, der von einer zentralen Öffnung in dem ringförmigen Teil aus nach oben verläuft, wobei dieser röhrenförmige Teil am oberen Ende offen ist, wo sich der Auslaß 47 des Behälters 36 befindet. Ein Rohrverbindungsstück 48 aus Edelstahl, das auf dem oberen Ende des röhrenförmigen Teils 46B der Abschlußkappe angebracht ist, verbindet den Behälter 36 über ein flexibles Rohr 52, vorzugsweise aus Edelstahl, mit einer Vakuumquelle. Eine Haltevorrichtung 54 für die Abschlußkappe 46 besteht aus einem Ring 56 mit mehreren axialen Bohrungen (nicht abgebildet) in regelmäßigen Abständen um den Ring herum und mehreren radialen Bohrungen 58, die kreisförmig um den Ring herum angeordnet sind. Bolzen 60 aus Edelstahl, die durch die radialen Bohrungen 58 in dem Ring hindurchgehen, greifen in den kreisförmigen Teil 46A der Abschlußkappe und halten diesen fest. Die Haltevorrichtung 54 ist am Körper 40 des Gehäuses mit Molybdän-Bolzen 62 befestigt, die durch Bohrungen im Körper hindurchgehen und bis in die radialen Bohrungen 58 im Ring 56 reichen.

Die Abschlußkappe 46 und die Haltevorrichtung 54, wie sie hier gezeigt werden, sind aus Edelstahl. Die Materialien für die Vorrichtung zum Herausziehen des Siliciums wurden wegen ihrer schwer schmelzbaren bzw. isolierenden Eigenschaften und/oder ihrer chemischen Widerstandsfähigkeit gegenüber der Atmosphäre des Ofens 10 gewählt. Es wird jedoch darauf hingewiesen, daß auch andere Materialien als die hier genannten verwendet werden können, solange sie die hierfür erforderlichen Eigenschaften aufweisen.

Vor dem Anbringen der Haltevorrichtung 54 am Gehäusekörper 40 muß das Gehäuse 38 mit einer wärmeisolierenden Schicht ausgekleidet werden. Die Auskleidung besteht aus einer festen Graphitauskleidung einschließlich einer ringförmigen Basis 66 mit einer zentralen Gewindeöffnung 66A, einem röhrenförmigen Teil 68 und einer ringförmigen Abdeckplatte 70. Bei der bevorzugten Ausführungsart besteht die feste Auskleidung 64 aus gereinigtem extrudiertem Graphit, weist eine Mindestdicke von etwa 0,63 cm bei Behältern mit einem Durchmesser von unter 10 cm und eine Mindestdicke von etwa 1 cm bei Behältern mit größerem Durchmesser auf. Ein Zuleitungsrohr 72 ist so beschaffen, daß es geschmolzenes Ausgangsmaterial aus dem Schmelztiegel 24 in den Behälter 36 befördern kann. Das Zuleitungsrohr 72 hat ein Außengewinde und kann in die Gewindeöffnung 66A in der Basis 66 geschraubt werden, um eine dichte Verbindung mit der Basis herzustellen. Gemeinsam sind die Basis 66 und das Zuleitungsrohr 72 im Gehäuse 38 so angebracht, daß die Basis auf der Grundplatte 42 des Gehäuses ruht, wobei der untere Teil des Zuleitungsrohrs durch die Öffnung in der Grundplatte hindurchgeht und unterhalb des Behälters 36 herausragt und ein oberer Teil des Rohrs von der Grundplatte aus nach oben in den vom Behälter umschlossenen Raum hineinragt.

Nach Einschieben des röhrenförmigen Teils 68 der festen Auskleidung 64 in das Gehäuse 38 wird eine Auskleidung 74 aus Graphitfilz in dem Gehäuse 38 vorgesehen.

Die Auskleidung 74 besteht aus einem ringförmigen Grundelement 74A, das so beschaffen ist, daß das Zuleitungsrohr 72 durch seine zentrale Öffnung paßt, und einem röhrenförmigen Element 74B, das die nach innen zeigende Wand des röhrenförmigen Teils 68 der festen Graphit-Auskleidung 64 bedeckt, und ist so beschaffen, daß es sich beim Erstarren des Siliciums im Behälter 36 zusammenpreßt, so daß der röhrenförmige Teil und die Basis der festen Graphitauskleidung vor Beschädigung geschützt werden. Eine einzelne Schicht der Auskleidung 74 mit einer Dicke von ca. 0,63 cm ist für Behälter mit einem Durchmesser von ca. 12,6 cm oder weniger ausreichend. Für Behälter mit größerem Durchmesser wird eine zweite Schicht (nicht abgebildet) einer ca. 0,63 cm dicken Auskleidung verwendet. Die Abdeckplatte 70 liegt auf dem oberen Ende des röhrenförmigen Teils 68 der festen Graphitauskleidung 64 auf. Unterhalb der zentralen Öffnung der Abdeckplatte hängt an zwei Aufhängern 78 aus Molybdän ein umgekehrt angebrachter, becherförmiger Ablenker 76 von der Abdeckplatte herunter. Der Ablenker 76 soll das in den Behälter 36 eingezogene Silicium daran hindern, durch den direkt darüber liegenden Auslaß 47 zu entweichen, ermöglicht jedoch das Vorbeiströmen von Gasen darum herum und auch aus dem Behälter heraus, um das Vakuum im Behälter aufrecht zu erhalten. Die Befestigung der Haltevorrichtung 54 am Gehäuse 38 sorgt für einen dichten Kontakt der Basis 66 der festen Graphitauskleidung mit der Grundplatte 42 des Gehäuses. Die Haltevorrichtung 54 erleichtert auch das Abdichten an den Übergangsstellen zwischen dem röhrenförmigen Teil 68 und der Basis 66 der festen Graphitauskleidung 64 und zwischen dem röhrenförmigen Teil 68 und der Abdeckplatte 70, indem sie sie fest zusammendrückt.

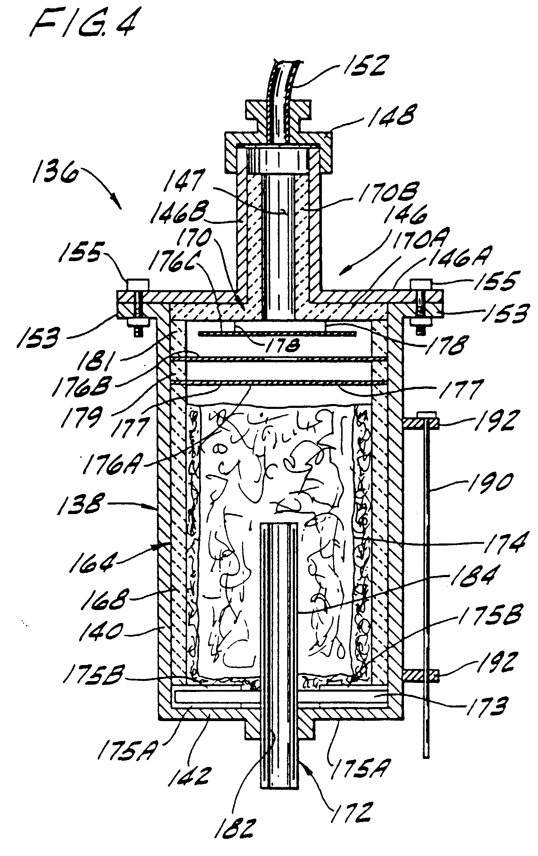

Das Zuleitungsrohr 72 gemäß Fig 3 und 4 besteht aus Quarzglas der Güteklasse für Halbleiteranwendungen. Es weist eine Innenwand 82 und eine Außenwand 84 auf, die am oberen und unteren Ende miteinander verschmolzen sind und dazwischen einen zylinderförmigen Raum 86 bilden. Bei den abgebildeten Ausführungen hat die Innenwand 82 eine Dicke von ca. 0,1 cm und die Außenwand 84 weist eine Dicke von ca. 0,15 cm auf. Der äußere Durchmesser der Außenwand 84 beträgt ca. 1,98 cm und der innere Durchmesser der Innenwand 82 liegt bei ca. 1,19 cm. In der Außenwand 84 befindet sich eine Entlüftungsöffnung 88, damit Überdruck aus dem Raum 86 entweichen kann, wenn das Zuleitungsrohr der Hitze im Ofen 10 ausgesetzt wird. Die Außenwand 84 ist mit einem Gewinde versehen, damit eine dichte Verbindung mit der Gewindeöffnung 66A in der Basis 66 der festen Graphitauskleidung 64 gewährleistet ist. Wie weiter unten näher beschrieben wird, soll durch die doppelwandige Bauweise des Zuleitungsrohrs 72 verhindert werden, daß Teile vom Rohr abbrechen und in die Siliciumschmelze 25 im Schmelztiegel 24 fallen.

Ein Stab 90, der an der Außenseite des Gehäusekörpers 40 angebracht ist, dient zum Abmessen der Eindringtiefe des unteren Endes des Zuleitungsrohrs 72 in die Siliciumschmelze 25, damit eine zuvor festgelegte Menge der Siliciumschmelze entnommen wird. Der Stab 90 ist aus dem gleichen hochreinen Quarzglas wie das Zuleitungsrohr 72 und ist an Schellen 92 aus Molybdän am zylindrischen Körper 40 befestigt. Die Schellen 92 sind am zylindrischen Körper 40 mit einem der Bolzen (62, 44) festgemacht, wie sie zur Anbringung des Haltevorrichtungsrings 56 und der Grundplatte 42 am Gehäusekörper verwendet wurden. Der Stab 90 geht durch die Öffnungen in den Schellen 92 und hat an seinem oberen Ende einen Flansch 94, der von der oberen Schelle 92 getragen wird, so daß der Stab über den Boden des Behälters 36 mit einer vorgegebenen Distanz hinausragt. Das Einführen des unteren Endes des Zuleitungsrohrs 72 wird in dem Moment gestoppt, wenn das untere Ende des Stabes 90 die Oberfläche der Siliciumschmelze 25 im Behälter 24 berührt (d.h. der Stab zeigt dem Bedienpersonal an, daß dieser Punkt erreicht ist).

Eine zweite Ausführungsform für den Behälter, die durchweg mit 136 bezeichnet wird, ist in Fig. 4 zu sehen. Teile des Behälters 136, die denjenigen im Behälter 36 der ersten Ausführungsform entsprechen, tragen die gleiche Bezugsziffer, jedoch mit einer "1" davor. Der Behälter 136 besteht aus einem Gehäuse 138 aus rostfreiem Stahl mit einem einteiligen Körper 140, der eine integrierte, ringförmige Bodenwandung 142 hat, und einer Abschlußkappe 146 mit einem äußeren ringförmigen Teil 146A und einem röhrenförmigen Teil 146B, das sich zentral nach oben erstreckt. Ein Rohrverbindungsstück 148 verbindet ein flexibles Rohr 152 aus Edelstahl mit einer Vakuumquelle. Die Abschlußkappe 146 wird gestützt von einem integrierten, radial nach außen verlaufenden Flansch 153 am oberen Ende des Körpers 140. Ein Zuleitungsrohr 172 ist im wesentlichen baugleich mit dem bereits beschriebenen Zuleitungsrohr 72, außer daß seine Außenwand 184 kein Außengewinde aufweist. Das Zuleitungsrohr 172 ist mit einem ringförmigen Flansch 173 aus Quarz verschmolzen und in den Körper 140 auf einer ringförmigen Dichtung 175A aus Graphit-Filz eingesetzt, die auf der unteren Wandung 142 des Körpers 140 aufliegt. Eine zweite ringförmige Dichtung 175B aus Graphit-Filz befindet sich zwischen dem Flansch 173 und dem unteren Ende eines darunterliegenden röhrenförmigen Teils 168 einer festen Graphitauskleidung 164. Es hat sich gezeigt, daß die Dichtungen 175A und 175B aus Graphit-Filz erforderlich sind, um den Unterdruck im Behälter 136 der zweiten Ausführungsform aufrecht zu erhalten, daß solche Dichtungen jedoch im Behälter 36 der ersten Ausführungsform nicht erforderlich sind. Die innere Wand des röhrenförmigen Teils 168 der festen Graphit-Auskleidung 164 ist in ihrem unteren Teil mit einer röhrenförmigen Schicht 174 von komprimierbarem Graphitfilz ausgekleidet.

Statt des umgekehrt angebrachten, becherförmigen Ablenkers 76 bei der ersten Ausführungsform ist bei der zweiten Ausführungsform der Erfindung ein ganzer Satz von aus Molybdän hergestellten Ablenkplatten, die mit 176A, 176B und 176C bezeichnet sind, im Behälter 136 angebracht. Die untere Ablenkplatte 176A, die vom unteren Teil 168 der röhrenförmigen Graphit-Auskleidung getragen wird, ist im allgemeinen kreisrund und weist eine Vielzahl von kreisförmigen Öffnungen 177 auf, die sich in einem Abstand vom mittleren Teil der unteren Ablenkplatte befinden. Von der dazwischenliegenden kreisförmigen Ablenkplatte 176B, die von der unteren Ablenkplatte 176A durch ein dazwischen liegendes, röhrenförmiges Element 179 aus Graphit-Auskleidung in einem Abstand gehalten wird, wird ein darüberliegendes, röhrenförmiges Element 181 aus Graphit-Auskleidung getragen. Die obere kreisförmige Ablenkplatte 176C hängt an Aufhängern 178 von einer Abdeckplatte 170 der festen Graphit-Auskleidung 164 herab, die auf dem oberen röhrenförmigen Element 181 der Graphit- Auskleidung ruht. Die Ablenkplatten 176A-176C sorgen für einen vielfach gewundenen Weg zwischen dem unteren Innenraum des Behälters und dem oberen Auslaß 147 des Behälters 136, den zwar Gase leicht passieren können, der jedoch verhindert, daß Silicium durch den Auslaß aus dem Behälter entweicht. Die Abdeckplatte 170 hat einen äußeren ringförmigen Teil 170A und einen integrierten röhrenförmigen Teil 170B, der nach oben in den röhrenförmigen Teil 146B der Abschlußkappe hineinragt. Ein Meßstab 190, der im wesentlichen mit dem Stab der ersten Ausführungsform identisch ist, wird mit Schellen 192 aus Edelstahl am Gehäusekörper 140 befestigt.

In beiden Ausführungen ist das Rohr aus Edelstahl (52, 152) im Inneren des Ofens 10 über eine Schnellverschluß Vakuumverbindung (nicht abgebildet) in der Wand der Ziehkammer 12 mit dem ersten Ventil V1 verbunden. Ein weiteres Rohr 96 aus Edelstahl reicht vom ersten Ventil V1 bis zu einem zweiten Ventil V2, das mit dem Rohrverbindungsstück 98 eines VakuumReservetanks 100 in Verbindung steht. Ein drittes Ventil V3, das an das Rohrverbindungsstück 98 angeschlossen ist, steuert die Kommunikation des Tanks 100 mit einer Vakuumpumpe (nicht abgebildet). Der Tank 100 und die Pumpe sind somit zusammen eine Vakuumquelle. Das Fassungsvermögen des Tanks 100 ist ungefähr 100 mal größer als das des Behälters 36, so daß es nicht zu einem höheren Druck im Behälter kommt, wenn das Zuleitungsrohr 72 während des Verfahrens zum Herausziehen des Siliciums aus der Siliciumschmelze 25 herausgezogen wird.

Das bekannte Verfahren zur Züchtung mehrerer hochreiner Siliciumkristalle aus einer einzigen, wiederaufgefüllten Siliciumschmelze 25 umfaßt im wesentlichen die Schritte des Schmelzens des festen polykristallinen Siliciums im Schmelztiegel 24 und der Züchtung eines monokristallinen Blocks, z.B. mit Hilfe des oben beschriebenen Czochralski-Verfahrens. Der Block wird aus der Kristall-Züchtungskammer 14 in die Ziehkammer 12 gezogen, und die Sicherheitsklappe 16 wird geschlossen, um die Kristall-Züchtungskammer von der Ziehkammer zu trennen. Der Druck in der Ziehkammer 12 wird nun auf den Umgebungsdruck im Ofenraum angehoben, und anschließend wird der Block durch eine Klappe (nicht abgebildet) in der Wand der Ziehkammer entfernt. Die nach dem ersten Züchtungsvorgang in der Schmelze 25 befindlichen Verunreinigungen, wie beispielsweise Eisen (Fe) und Kohlenstoff (C), haben bis dahin einen Konzentrationsgrad erreicht, daß der Gehalt an Verunreinigungen in einem zweiten Kristall, der aus der selben Schmelze gezüchtet wird, trotz des Zusatzes von frischem Silicium zu der Schmelze erheblich ansteigt. Nach der Züchtung eines zweiten Kristalls kann kein weiterer hochwertiger Kristall aus dem Schmelztiegel 24 gezüchtet werden, selbst wenn die Siliciumschmelze 25 mit frischem Silicium neu aufgefüllt wird. Nun ist das Ersetzen des Schmelztiegels 24 bzw. die Reinigung der Siliciumschmelze 25 im Schmelztiegel unumgänglich. Um die Lebensdauer der Schmelze 25 in dem Tiegel 24 zu optimieren, wird erfindungsgemäß nach jedem Kristall-Züchtungsvorgang ein Verfahren zum Herausziehen des Siliciums angewandt, bei dem die Schmelze gereinigt wird.

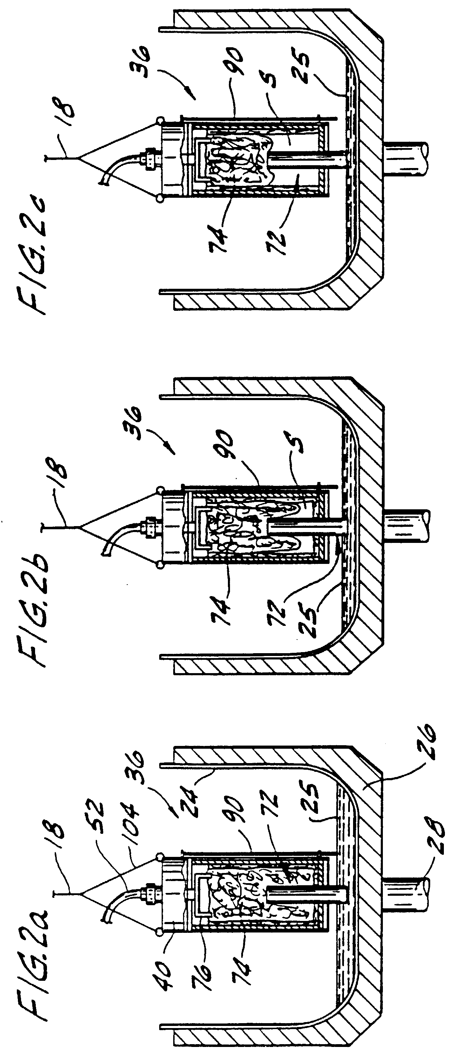

Zu Beginn des erfindungsgemäßen Verfahrens zum Herausziehen des Siliciums läßt man einen Behälter, wie beispielsweise den Behälter 36 der oben beschriebenen ersten Ausführungsform, an einem Kabel 104 aus Edelstahl vom Drahtzug 18 herabhängen. Das Rohrverbindungsstück 48 wird über dem oberen offenen Ende der Abschlußkappe 46 angebracht, um eine Verbindung zwischen dem Behälter 36 und dem in den Vakuumreservetank 100 führenden Rohr 52 herzustellen. Nun werden jedoch das erste und das zweite Ventil V1 und V2 geschlossen, damit der Druck im Behälter 36 dem Umgebungsdruck im Ofen 10 entspricht. Aus der Ziehkammer 12 wird solange Luft abgelassen, bis der Druck demjenigen in der Kristall-Züchtungskammer 14 entspricht. Nun wird die Sicherheitsklappe 16 geöffnet und der Kristall-Hebemechanismus 20 in Gang gesetzt, der den Behälter nach und nach in die Kristall-Züchtungskammer 14 herunterläßt. Beim Herunterlassen des Behälters 36 in den Schmelztiegel 24 taucht das untere Ende des Zuleitungsrohrs 72 in die Siliciumschmelze 25 ein, die nach jedem Kristall-Züchtungsvorgang im Schmelztiegel zurückbleibt. Die Abwärtsbewegung des Behälters 36 wird gestoppt, sobald der Meßstab 90 die Oberfläche der Schmelze 25 berührt. Der Behälter 36 befindet sich jetzt in der aus Fig. 2(a) ersichtlichen Stellung. Der vertikale Abstand zwischen dem unteren Ende des Zuleitungsrohrs 72 und dem unteren Ende des Meßstabs 90 wurde zuvor so eingestellt, daß das Zuleitungsrohr tief genug eindringt, um der Schmelze 25 eine festgelegte Menge Flüssigkeit entziehen zu können, bevor das untere Ende des Zuleitungsrohrs wieder aus der Schmelze herauskommt.

Der Druck in der Kristall-Züchtungskammer 14 wird auf etwa 3,03·10⁷Pa (300 Torr) angehoben, nachdem dem Vakuum-Reservetank 100 zuvor bis auf einen Druck von unter 3,03·10⁵Pa (3 Torr) Luft entzogen wurde. Das erste und das zweite Ventil V1 und V2 werden nun geöffnet, damit der Behälter 36 mit dem Vakuum-Reservetank 100 in Verbindung steht, wonach ein erheblicher Druckunterschied zwischen dem Inneren des Behälters und dem Umgebungsdruck in der Kristall-Züchtungskammer 14 besteht. Über das Zuleitungsrohr 72 wird nun in der in Fig. 2(b) dargestellten Weise unter Druck geschmolzenes Silicium S in den Behälter 36 eingebracht. Im isolierten Innenraum des Behälters 36 liegt die Temperatur deutlich unter dem Erstarrungspunkt für Silicium, so daß das in den Behälter eingeführte geschmolzene Silicium rasch fest wird. Durch die Auskleidung 74 aus Graphit-filz kann sich das Silicium während des Erstarrens ausdehnen, ohne daß die feste Graphit-Auskleidung 64 beschädigt wird. Nun wird eine ausreichende Menge der Schmelze 25 herausgezogen und das untere Ende des Zuleitungsrohrs 72 verläßt die Schmelze wieder, woraufhin kein flüssiges Silicium mehr in den Behälter 36 gelangen kann (Fig. 2(c)). Um ein Herausfließen des aus der Schmelze herausgezogenen Siliciums aus dem Behälter 36 zu verhindern, nachdem die Füllhöhe der Siliciumschmelze 25 in dem Schmelztiegel 24 sich unterhalb des Zuleitungsrohrs 72 befindet, zieht das Vakuumpuffersystem (d.h. der Vakuumreservetank 100) so lange weiter Gas in den Behälter, bis das herausgezogene Silicium fest wird.

Das bisher beschriebene und in den Fig. 2(a)-(c) illustrierte Verfahren kann als Verfahrensmodus "mit geringer Füllhöhe" bezeichnet werden, da das Fassungsvermögen des Behälters 36 groß genug ist und so die Füllhöhe des Siliciums im Behälter niemals über das obere Ende des Zuleitungsrohrs 72 ansteigt. Es ist jedoch auch ein "Überfüllungs"-Modus denkbar, bei dem die Füllhöhe des Siliciums über das obere Ende des Zuleitungsrohrs 72 ansteigt und den Auslaß 47 verstopft, so daß die Verbindung zu dem Vakuum im Vakuumreservetank abgeschnitten ist. In Fig. 6 ist eine dritte Ausführungsform des Behälters zur Verwendung im "Überfüllungs"-Modus dargestellt. Dieser Behälter 236 ist im wesentlichen baugleich mit demjenigen in der ersten Ausführungsform, und die entsprechenden Teile des Behälters sind mit den gleichen Zahlen versehen wie beim Behälter in der ersten Ausführungsform, jedoch wurde jeweils eine "2" vorangestellt. Ein Stopfen aus Edelstahl, der einen kleineren Durchmesser als der innere Durchmesser des röhrenförmigen Teils 246B der Abschlußkappe 246, jedoch einen größeren als der Durchmesser der Öffnung in der Abdeckplatte 270 der festen Graphit-Auskleidung 264 aufweist, befindet sich im röhrenförmigen Teil der Abschlußkappe. Der Gasfluß aus dem Behälter 236 hält den Stopfen 237 während des Herausziehens des Siliciums von der Abdeckplatte 270 weg. Der Behälter 236 ist schließlich so weit gefüllt, daß das Silicium S im Behälter um den äußeren Rand des Ablenkers 276 herum und weiter hinauf in den röhrenförmigen Teil 246B der Abschlußkappe gezogen wird. Beim Kontakt mit dem Stopfen 237 aus Edelstahl erstarrt das Silicium S sofort, so daß der Auslaß 247 rasch blockiert wird. Eine entsprechende Menge des Gases 249 wird unter geringem Druck im Behälter 236 eingeschlossen und dient dazu, das herausgezogene Silicium S im Behälter festzuhalten.

Das Zuleitungsrohr 72 wurde speziell dafür konzipiert, eine Verunreinigung der Schmelze 25 zu verhindern, während eine Teilmenge des flüssigen Siliciums aus der Schmelze herausgezogen wird. Es könnten Verunreinigungen in die Schmelze 25 eindringen, die aus der Auflösung des Zuleitungsrohrs 72 durch das flüssige Silicium herrühren, sobald das Zuleitungsrohr mit der Flüssigkeit in Verbindung kommt. Dies würde eindeutig das Ziel der Erfindung zunichte machen, das in der Reinhaltung der Siliciumschmelze 25 besteht. Eine weitere Verunreinigungsquelle könnten feste, langsam schmelzende oder auch stabile Abriebteilchen sein, die vom Zuleitungsrohr 72 abfallen. Feste Bestandteile in der Schmelze 25 können zu Fehlordnungen im Kristall führen, wenn sie mit dem heranwachsenden Kristall am äußeren Rand der Trennungsfläche zwischen Feststoff und Flüssigkeit in Berührung kommen. Ein Kristall-Block, der mit derartigen Fehlordnungen gezüchtet wird, wäre zum Einsatz in Halbleiter-Anwendungen ungeeignet und müßte daher verworfen werden. Jedoch ist das Quarzglas, aus dem das Zuleitungsrohr 72 hergestellt ist, das gleiche wie es zur Herstellung des Behälters 24 verwendet wurde, der die gleiche Reinheit aufweist wie das Silicium, aus dem die Kristalle gezüchtet werden. Obgleich sich während des erfindungsgemäßen Verfahrens eine kleine Menge des Quarzglases auflöst, bleibt der Grad der Verunreinigungen im Glas so niedrig, daß die Schmelze 25 davon nicht verunreinigt wird.

Das Quarzglas ist bei der in der Kristall-Züchtungskammer 14 herrschenden Temperatur, die direkt unter der des Schmelzpunktes für Silicium liegt, sehr spröde, so daß man vor dem Problem steht, zu verhindern, daß Teile vom Zuleitungsrohr 72 abbrechen und in den Rest der Schmelze 25 fallen. Bei Verwendung des "Überfüllungs"-Modus (Fig. 6) enthält das Zuleitungsrohr 272 nach erfolgtem Herausziehen des flüssigen Siliciums aus der Schmelze Silicium. Während das Silicium erstarrt und sich dabei ausdehnt, besteht ein erhebliches Risiko, daß radiale äußere Risse und ein Abblättern der Innenwand 282 des Zuleitungsrohrs 272 auftreten. Selbst bei Verwendung des Verfahrensmodus mit geringer Füllhöhe (Fig. 2(a)-2(c)) bleibt wegen der Oberflächenspannung der Flüssigkeit etwas flüssiges Silicium an der Innenwand 82 des Zuleitungsrohrs 72 hängen. Beim Erstarren und Ausdehnen dieser Tropfen flüssigen Siliciums kann es zu Rissen und Abblättern der Innenwand 82 kommen. Bei beiden Verfahrensweisen enthält jedoch die Außenwand 84, 284 des Zuleitungsrohrs eventuelle Bruchfragmente der Innenwand 82, so daß von der Innenwand keine Teile in die Schmelze 25 fallen können. Bei dem Modus mit geringer Füllhöhe kann das Erstarren des Siliciums im Inneren des Behälters 36 zu einer Kompression der Außenwand 84 des Zuleitungsrohrs und so zum Bruch dieser Außenwand führen. In diesem Fall verhindert jedoch die Innenwand 82, daß Teile der Außenwand 84 in das Zuleitungsrohr 72 und so in die Schmelze 25 fallen.

Nach dem Herausziehen des flüssigen Siliciums aus der Schmelze wird der Kristall-Hebemechanismus 20 betätigt, um den Behälter 36 aus dem Schmelztiegel 24 und aus der Kristall-Züchtungskammer 14 herauszuheben. Nachdem die Ziehkammer 12 erreicht ist, wird die Sicherheitsklappe 16 geschlossen, um die Kristall-Züchtungskammer 14 von der Ziehkammer zu trennen. Der Druck in der Ziehkammer 12 wird dem Umgebungsdruck im Ofenraum angepaßt und die Verbindung des Behälters 36 mit der Rohrleitung 52 und dem Drahtzug 18 gelöst. Der Behälter 36 wird nun aus der Ziehkammer 12 herausgenommen und der Keimhalter mit einem neuen Kristallkeim am Drahtzug 18 befestigt. Bei Anwendung des Chargen-Nachfüllverfahrens gemäß Czochralski wird der Schmelze 25 an dieser Stelle frisches Silicium zugesetzt. Danach werden die für die Kristallzüchtung erforderlichen Temperatur- und Druckbedingungen in der Kristall-Züchtungskammer 14 wiederhergestellt und ein weiterer hochreiner Kristall gezüchtet.

Nachdem der Behälter 36 aus der Ziehkammer 12 herausgenommen wurde, werden die Haltevorrichtung 54 und die Abschlußkappe 46 entfernt. Das aus der Schmelze herausgezogene Silicium, die Graphitfilz-Auskleidung 74 und das Zuleitungsrohr 72 werden aus dem Gehäuse 38 entfernt und weggeworfen. Das Gehäuse 38 und häufig auch die feste Graphit-Auskleidung 64 können mit neuer Graphitfilz-Auskleidung und neuem Zuleitungsrohr beim nächsten Herausziehen wieder verwendet werden.

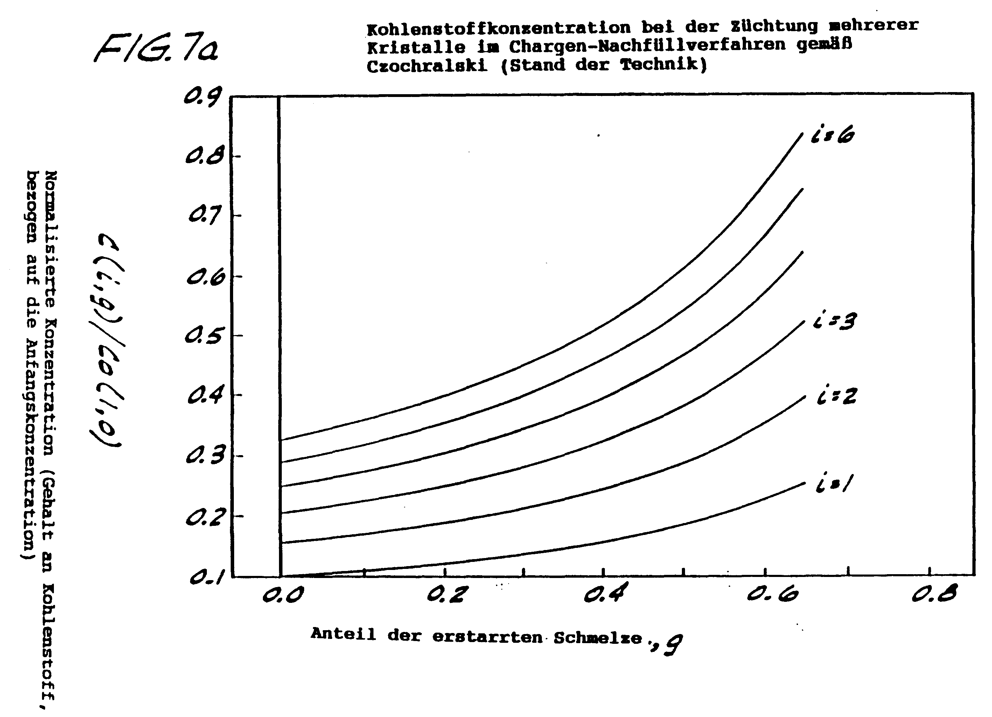

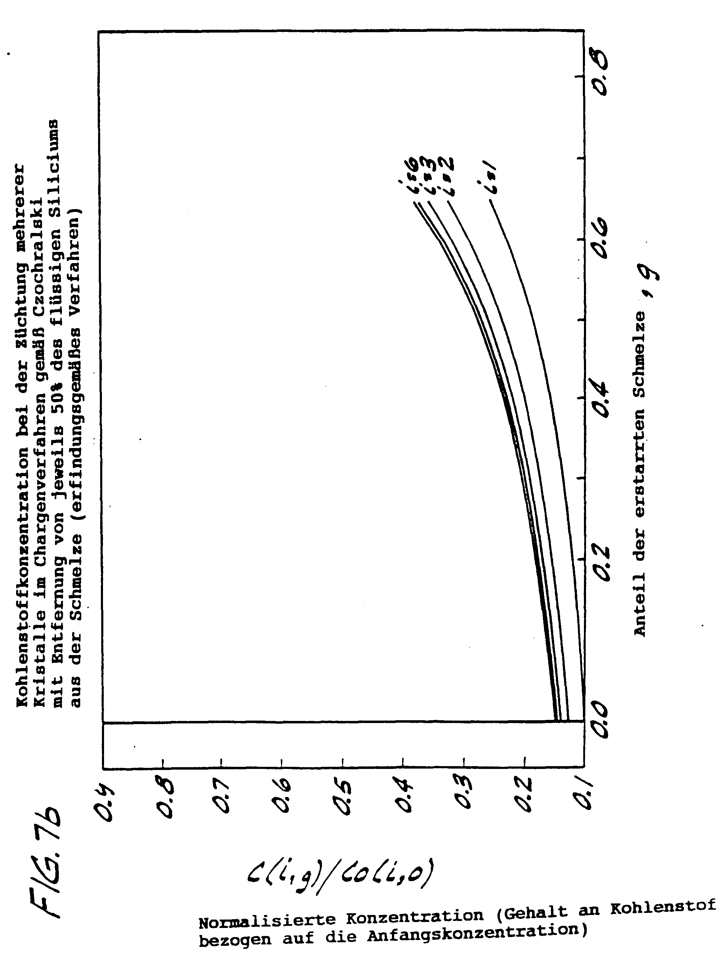

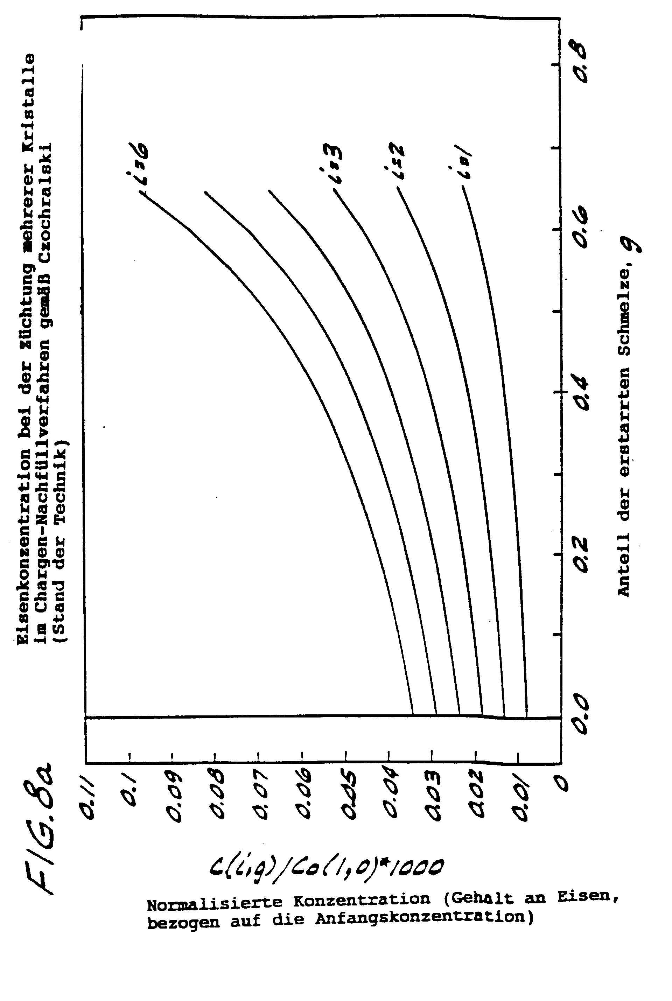

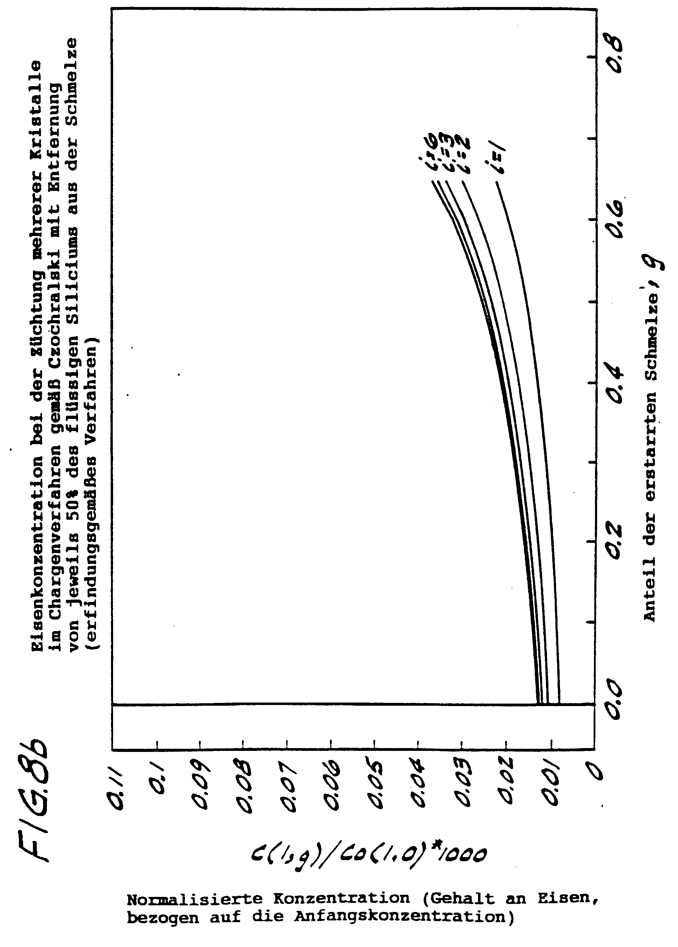

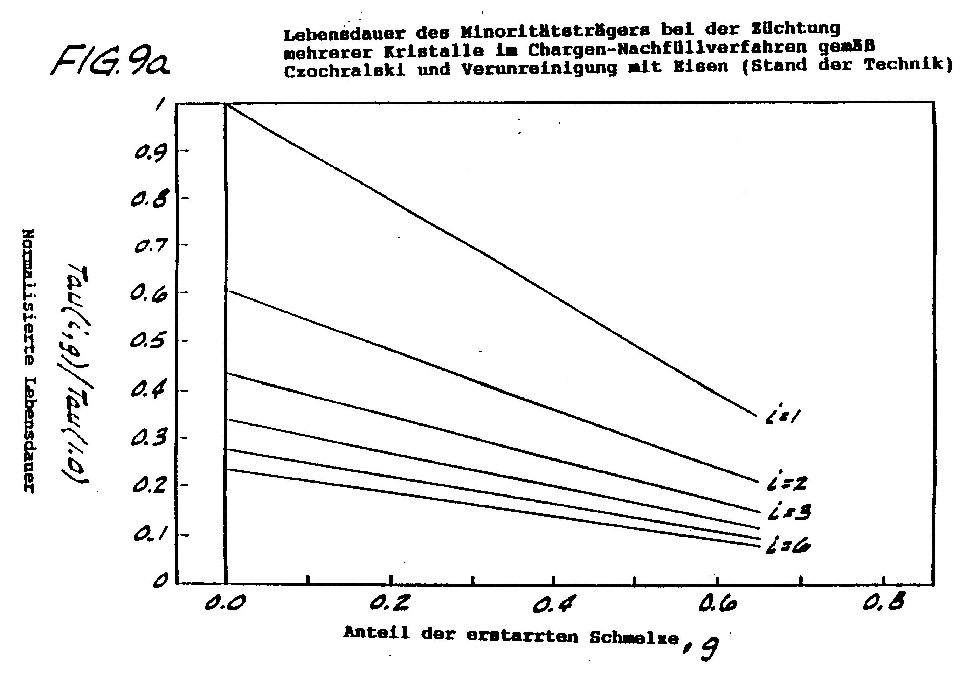

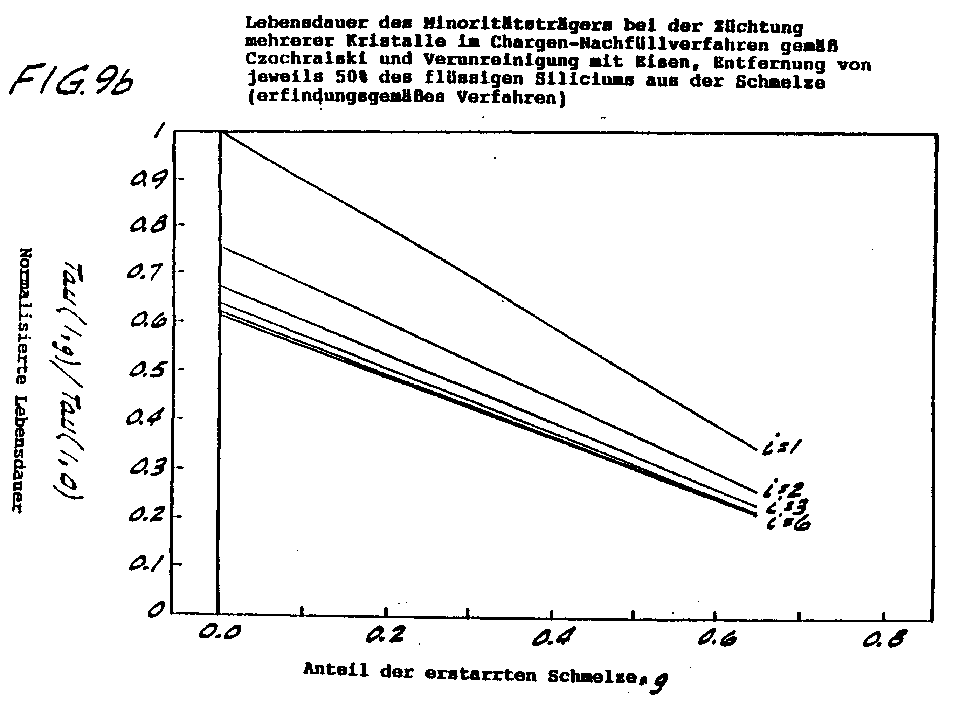

Es wurde festgestellt, daß mit dem hier beschriebenen Verfahren, bei dem 50 % der Menge an flüssigem Silicium, die nach jeder Züchtung eines Kristalls in der Schmelze 25 zurückbleibt, entfernt werden, mindestens sechs Kristalle gezüchtet werden können, ohne daß der Schmelztiegel 24 durch einen neuen Tiegel mit völlig frischem Silicium ersetzt werden muß. Der Gehalt des n-ten gezüchteten Kristalls an der Verunreinigung Kohlenstoff (C) ohne Einsatz des erfindungsgemäßen Verfahrens wurde mit dem Gehalt an Verunreinigungen verglichen, der bei Anwendung des beanspruchten Verfahrens entsteht. Das Ergebnis des Vergleichs ist in den Fig. 7(a) und 7(b) graphisch dargestellt. Derselbe Vergleich wird für die Verunreinigung Eisen (Fe) angestellt und in den Fig. 8(a) und 8(b) veranschaulicht. Im einzelnen zeigen die Kurven den Gehalt des Kristalls an der betreffenden Verunreinigung (normalisiert durch die anfängliche Konzentration der Verunreinigung im polykristallinen Silicium-Ausgangsmaterial) gegenüber dem Anteil der erstarrten Schmelze. Wie zu erkennen ist, unterscheidet sich bei Anwendung des erfindungsgemäßen Verfahrens die Konzentration der Verunreinigungen im sechsten gezüchteten Kristall nur unwesentlich von der Konzentration der Verunreinigungen im zweiten gezüchteten Kristall, bei dem kein Herausziehen des Siliciums aus der Schmelze erfolgte.

Ein ähnlicher Vergleich wurde für die Verunreinigung Fe angestellt und ist in den Fig. 9(a) und 9(b) dargestellt. Die Kurven zeigen die errechnete Lebensdauer des Minoritätsträgers (d.h. die Zeitspanne, während der der Siliciumkristall eine elektrische Ladung halten kann) gegenüber dem Anteil des Silicium in der Schmelze, der kristallisiert erstarrt ist. Die Lebensdauer des Kristalls ist eine wesentliche Eigenschaft, die zur Beurteilung der Eignung eines Kristalls für Halbleiter-Anwendungen heranzogen wird, für die er vorgesehen ist. Die Lebensdauer eines bestimmten Kristalls hängt von der Menge der darin enthaltenen Verunreinigungen (in diesem Fall Fe) ab. Um die Berechnungen verallgemeinern zu können, wurde die Lebensdauer, Tau, durch die Lebensdauer des Keimkristall-Endes des ersten aus der Schmelze gezüchteten Kristalls normalisiert. Die Lebensdauer der Kristalle, die unter Verwendung des hier beschriebenen Verfahrens gezüchtet wurden, fällt wesentlich langsamer ab (insbesondere nach Züchtung des zweiten Kristalls) als die Lebensdauer der aus einer einzigen, wiederaufgefüllten Schmelze gemäß dem Stand der Technik gewonnenen Kristalle.

Die vorstehenden Ausführungen belegen die Überlegenheit des erfindungsgemäßen Verfahrens gegenüber dem Stand der Technik.

## Patentansprüche

1. Verfahren zur Züchtung mehrerer hochreiner Einkristalle aus einer wiederaufgefüllten Schmelze (25) unter Aufrechterhaltung der Reinheit des geschmolzenen Ausgangsmaterials in der Schmelze, die sich in einem Schmelztiegel (24) und dieser in einem Ofen (10) von der Art befindet, wie er zur Züchtung hochreiner Einkristalle verwendet wird,
**dadurch gekennzeichnet**, daß man
a) mindestens einen Kristall aus dem Ausgangsmaterial im Schmelztiegel (24) züchtet;
b) anschließend eine ausreichende Teilmenge der im Schmelztiegel verbleibenden Schmelze entnimmt, wobei in der Schmelze enthaltene Verunreinigungen, die während der Züchtung mindestens eines Kristalls in der Flüssigkeit verbleiben, mit der entnommenen flüssigen Teilmenge entfernt werden;
c) danach der Schmelze (25) hochreines Ausgangsmaterial zusetzt und
d) schließlich mindestens einen weiteren hochreinen Einkristall züchtet.

2. Verfahren nach Anspruch 1, dadurch gekennzeichnet, daß man während der Züchtung des Kristalls und während der Entnahme einer Teilmenge aus der im Schmelztiegel (24) verbleibenden Schmelze (25) der Schmelze (25) ständig hochreines Ausgangsmaterial zusetzt.

3. Verfahren nach Anspruch 1 oder 2, dadurch kennzeichnet, daß die Entnahme einer Teilmenge der Schmelze (25) aus mehreren Schritten besteht, nämlich dem Einstellen eines Behälters (36) in den Ofen (10), dem Herablassen des Behälters, bis dieser die Schmelze (25) berührt, und dem Einführen von Ausgangsmaterial in den Behälter.

4. Verfahren nach einem der Ansprüche 1 bis 3, dadurch gekennzeichnet, daß man der Schmelze (25) etwa 50% der Gesamtmenge entnimmt.

5. Verfahren nach Anspruch 3, dadurch gekennzeichnet, daß das Einführen von Ausgangsmaterial in den Behälter (36) mittels Anlegen von Vakuum an diesen Behälter erreicht wird.

6. Verfahren nach Anspruch 5, dadurch gekennzeichnet, daß man an den Behälter (36) solange Vakuum anlegt, bis sich das Ausgangsmaterial im Behälter verfestigt und die Verbindung zwischen Behälter und Vakuumquelle blockiert.

7. Verfahren nach Anspruch 3, dadurch gekennzeichnet, daß man den Behälter (36) bis zu einer vorher festgelegten Eindringtiefe in die Schmelze (25) herabläßt.

8. Verfahren nach einem der Ansprüche 1 bis 7, dadurch gekennzeichnet, daß man mindestens einen Kristall mit Hilfe des Czochralski-Verfahrens züchtet, indem man einen Kristall auf einem Drahtzug (18) aus der Schmelze (25) nach oben zieht, und bei dem man der Schmelze (25) eine Teilmenge dadurch entnimmt, daß man den Behälter (36) auf dem Drahtzug (18), in den Ofen (10) hängt, den Behälter bis zum Berühren der Schmelze herunterläßt und Ausgangsmaterial in den Behälter einführt.

9. Vorrichtung zur Verwendung bei der Züchtung mehrerer hochreiner Einkristalle aus einer wiederaufgefüllten Schmelze (25) von Ausgangsmaterial, die sich in einem Schmelztiegel (24) und dieser in einem Ofen (10) befindet, wie er zur Züchtung hochreiner Einkristalle verwendet wird, unter Aufrechterhaltung der Reinheit des Ausgangsmaterials in der Schmelze, bestehend aus:
a) einem Behälter (36) mit geeignetem Fassungsvermögen zur Aufnahme von geschmolzenem Ausgangsmaterial;
b) einer Vorrichtung (64) zur Wärmeisolierung des Behälterinhaltes;
c) einem Zuleitungselement (72), das mit dem Behälter (36) in Verbindung steht und geschmolzenes Ausgangsmaterial in den Behälter befördert, wobei besagtes Zuleitungselement aus einem Material gefertigt ist, das eine Verunreinigung der Ausgangsmaterial-Schmelze (25) verhindert, wenn ein Teil des besagten Zuleitungselementes sich in der Schmelze auflöst; und
d) einer Vorrichtung zum Einbringen von geschmolzenem Ausgangsmaterial in den Behälter (36).

10. Vorrichtung nach Anspruch 9, dadurch gekennzeichnet, daß das Zuleitungselement (72) sich zusammensetzt aus einem röhrenförmigen Teil mit offenen Enden und einer im allgemeinen zylinderförmigen Innenwand (82) sowie einer im allgemeinen ebenfalls zylinderförmigen Außenwand (84), die mit der Innenwand verbunden ist, so daß zwischen Innen- und Außenwand ein Raum gebildet wird.

11. Vorrichtung nach Anspruch 9 oder 10, dadurch gekennzeichnet, daß neben dem Zuleitungselement (72) zusätzlich eine Öffnung im Behälter (36) und ein Element (66, 66A)zur dichten Verbindung zwischen dem röhrenförmigen Teil und der Öffnung vorhanden sind.

12. Vorrichtung nach einem der Ansprüche 9 bis 11, dadurch gekennzeichnet, daß das Zuleitungselement (72) aus einem röhrenförmigen Teil aus Quarzglas der Güteklasse für Halbleiter-Anwendungen besteht.

13. Vorrichtung nach Anspruch 12, gekennzeichnet durch ein Meßinstrument zur Anzeige einer zuvor festgelegten Eindringtiefe.

14. Vorrichtung nach Anspruch 13, dadurch gekennzeichnet, daß das Meßinstrument aus einem Meßstab (90) besteht, der an dem Behälter (36) befestigt ist und sich unterhalb des Behälters in einer Länge fortsetzt, die nicht bis zum Ende des röhrenförmigen Elementes (72) reicht.

15. Vorrichtung nach Anspruch 9, dadurch gekennzeichnet, daß die Vorrichtung zum Einführen von Schmelze (25) in den Behälter (36) aus einer Vakuumquelle und einem Element (52, 96) besteht, das den Behälter mit der Vakuumquelle verbindet.

16. Vorrichtung nach Anspruch 15, dadurch gekennzeichnet, daß die Vakuumquelle eine Vorrichtung zur Aufrechterhaltung des Luftdrucks im Behälter (36) aufweist.

17. Vorrichtung nach Anspruch 16, gekennzeichnet durch einen Tank (100), der mit dem Behälter (36) in Verbindung steht, wobei der Tank (100) ein Fassungsvermögen aufweist, das etwa dem 100fachen des Fassungsvermögens des Behälters (36) entspricht.

18. Vorrichtung nach Anspruch 15, dadurch gekennzeichnet, daß der Behälter (36) einen Auslaß aufweist und das Element (52, 96) aus einer flexiblen Rohrleitung besteht, die mit dem Behälter (36) und der Vakuumquelle verbunden ist.

19. Vorrichtung nach Anspruch 18, dadurch gekennzeichnet, daß die flexible Rohrleitung aus einem Edelstahlrohr besteht.

20. Vorrichtung nach Anspruch 9, dadurch gekennzeichnet, daß der Behälter (36) aus einem Gehäuse (40) besteht und die besagte Vorrichtung (64) zur Wärmeisolation in der Auskleidung (74) des Gehäuses besteht, wobei das Auskleidungsmaterial sich aus einer Schicht komprimierbarer Ausfütterung zusammensetzt, die sich zusammendrückt, sobald das erstarrende Ausgangsmaterial sich im Behälter (36) ausdehnt, und so die besagte Auskleidung vor Beschädigung schützt.

## Claims

1. A method for growing multiple high-purity single crystals from a replenished melt (25) by maintaining the purity of molten source material in the melt held in a crucible (24) in a fumace (10) of the type used for growing high-purity single crystals,
**characterized in that** it comprises the steps of:
(a) growing at least one crystal from the source material in the crucible (24);
(b) extracting a sufficient portion of a volume of the melt (25) remaining in the crucible (24), whereby impurities in the melt remaining in liquid during said step of growing at least one crystal are removed with the extracted liquid portion;
(c) adding high-purity source material to the melt (25); and
(d) growing at least one more high-purity single crystal.

2. A method according to claim 1,
**characterized in that** high-purity source material is continuously added to the melt (25) throughout said crystal growing step and throughout said extraction of a portion of a volume of the melt (25) remaining in the crucible (24).

3. A method according to claim 1 or 2,
**characterized in that** said step of extracting a portion of a volume of the melt (25) comprises several steps, namely inserting a receptacle (36) into the fumace (10), lowering the receptacle down into contact with the melt (25), and admitting source material into the receptacle.

4. A method according to one of claims 1 to 3,
**characterized in that** approximately 50 % of the volume of the melt (25) is extracted.

5. A method according to claim 3,
**characterized in that** said step of admitting source material into the receptacle (36) is achieved by applying a vacuum pressure to the receptacle.

6. A method according to claim 5,
**characterized in that** vacuum pressure is applied to the receptacle (36) until source material solidifying in the receptacle blocks communication of the receptacle with the vacuum source.

7. A method according to claim 3,
**characterized in that** the receptacle (36) is lowered down into the melt (25) to a predetermined depth.

8. A method according to one of claims 1 to 7,
**characterized in that** at least one crystal is grown by the Czochralski method, in that a crystal is pulled upwardly out of the melt (25) on a pulling wire (18), and wherein said extraction of a portion of a volume of the melt (25) is performed by hanging a receptacle (36) in the furnace (10) on the pulling wire, lowering the receptacle down into contact with the melt, and admitting source material into the receptacle.

9. A device for use in growing multiple high-purity single crystals from a replenished melt (25) of source material contained in a crucible (24) in a fumace (10) of the type used for growing high-purity single crystals by maintaining the purity of the source material in the melt, consisting of:
a) a receptacle (36) enclosing a volume adapted to receive molten source material therein;
b) means (64) for thermally insulating the volume in the receptacle; and
c) inlet means (72) associated with the receptacle (36) for conducting molten source material into the receptacle, said inlet means being formed of a material which will not contaminate the source material melt when a portion of said inlet means dissolves in the melt; and
d) means for drawing molten source material into the receptacle (36).

10. A device according to claim 9,
**characterized in that** said inlet means (72) comprises a tubular member having open ends and including an inner generally cylindrical wall (82) and an outer generally cylindrical wall (84) joined to the inner wall, the inner and outer walls defining a space between them.

11. A device according to claim 9 or 10,
**characterized in that** it comprises in addition to said inlet means (72) and opening in the receptacle (36) as well as means (66, 66A) for sealably connecting the tubular member and the opening.

12. A device according to one of claims 9 to 11,
**characterized in that** said inlet means (72) comprises a tubular member being formed from semiconductor grade quartz glass.

13. A device according to claim 12,
**characterized by** gauge means for indicating a predetermined depth of insertion.

14. A device according to claim 13,
**characterized in that** said gauge means comprises rod means (90) mounted on the receptacle (36) and extending below the receptacle to a distance less than the end of the tubular member (72).

15. A device according to claim 9,
**characterized in that** said means for drawing melt (25) into the receptacle (36) comprises a vacuum source and means (52, 96) connecting the receptacle to the vacuum source.

16. A device according to claim 15,
**characterized in that** said vacuum source comprises means for maintaining vacuum pressure in the receptacle (36).

17. A device according to claim 16,
**characterized by** a tank (100) in communication with the receptacle (36), said tank (100) having a volume approximately one hundred times the volume enclosed by the receptacle (36).

18. A device according to claim 15,
**characterized in that** the receptacle (36) has an outlet and said connecting means (52, 96) comprises flexible conduit means connected to the receptacle (36) and connected to the source of vacuum pressure.

19. A device according to claim 18,
**characterized in that** said flexible conduit means comprises a length of stainless steel tubing.

20. A device according to claim 9,
**characterized in that** the receptacle (36) consists of a shell (40), and said thermal insulation means (64) consists of liner means (74) received in the shell, said liner means including a layer of compressible lining adapted to be compressed upon expansion of the freezing source material in the receptacle (36) for protecting said liner means from damage.

## Revendications

1. Procédé pour la croissance de plusieurs monocristaux de grande pureté à partir d'une masse en fusion complétée (25) en maintenant la pureté de la matière initiale fondue dans la masse en fusion placée dans un creuset (24) lui-même placé dans un four (10) du type de ceux utilisés pour la croissance de monocristaux de grande pureté,
caractérisé en ce que
a) l'on effectue dans le creuset (24) la croissance d'au minimum un cristal de la matière initiale ;
b) l'on prélève ensuite un volume partiel suffisant de la masse en fusion restant dans le creuset en éliminant avec le volume partiel liquide prélevé des impuretés contenues dans la masse en fusion, impuretés restant dans le liquide pendant la croissance d'au moins un cristal ;
c) l'on rajoute alors à la masse en fusion (25) de la matière initiale de grande pureté et
d) l'on effectue enfin la croissance d'au moins un autre monocristal de grande pureté.

2. Procédé selon la revendication 1, caractérisé en ce que l'on ajoute à la masse en fusion (25) en permanence de la matière initiale de grande pureté, pendant la croissance du cristal et pendant le prélèvement d'un volume partiel à partir de la masse en fusion (25) restant dans le creuset (24).

3. Procédé selon l'une quelconque des revendications 1 ou 2, caractérisé en ce que le prélèvement d'un volume partiel de la masse en fusion (25) se fait en plusieurs étapes, à savoir la mise en place d'un récipient (36) dans le four (10), la descente du récipient jusqu'au contact avec la masse en fusion (25) et l'introduction de matière initiale dans le récipient.

4. Procédé selon l'une quelconque des revendications 1 à 3, caractérisé en ce que l'on prélève environ 50% du volume total de la masse en fusion (25).

5. Procédé selon la revendication 3, caractérisé en ce que l'introduction de matière initiale dans le récipient (36) se fait par création d'un vide dans ce récipient.

6. Procédé selon la revendication 5, caractérisé en ce que l'on fait le vide dans le récipient jusqu'au moment où la matière initiale placée dans le récipient (36) se solidifie et bloque la liaison entre le récipient et la source de vide.

7. Procédé selon la revendication 3, caractérisé en ce que l'on descend le récipient (36) dans la masse en fusion (25) jusqu'à une profondeur de pénétration prédéfinie.

8. Procédé selon l'une quelconque des revendications 1 à 7, caractérisé en ce que l'on effectue la croissance d'au moins un cristal selon le procédé de Czochralski en tirant vers le haut un cristal de la masse en fusion (25) sur un câble de traction et en ce que l'on prélève à la masse en fusion (25) un volume partiel en accrochant le récipient (36) sur le câble de traction (18) dans le four (10), qu'on le descend jusqu'au contact de la masse en fusion et qu'on introduit de la matière initiale dans le récipient.

9. Appareillage pour la croissance de plusieurs monocristaux de grande pureté à partir d'une masse en fusion complétée (25) de matière initiale placée dans un creuset (24) lui-même placé dans un four (10) du type de ceux utilisés pour la croissance de monocristaux de grande pureté, en maintenant la pureté de la matière initiale dans la masse en fusion, comprenant :
(a) un récipient (36) de capacité suffisante pour recevoir la matière initiale fondue ;
(b) un dispositif (64) pour l'isolation thermique du contenu du récipient ;
(c) un élément d'alimentation (72) relié au récipient (36) et transportant de la matière initiale fondue dans le récipient, ledit élément d'alimentation étant fait dans un matériau évitant une pollution de la masse de matière initiale en fusion (25) si une partie dudit élément d'alimentation se dissout dans la masse en fusion, et
d) un dispositif d'introduction de matière initiale fondue dans le récipient (36).

10. Appareillage selon la revendication 9, caractérisé en ce que l'élément d'alimentation (72) se compose d'une partie en forme de tube à extrémités ouvertes et d'une paroi intérieure généralement cylindrique (82) ainsi que d'une paroi extérieure également généralement cylindrique (84) en liaison avec la paroi intérieure de manière à former un espace entre les parois intérieure et extérieure.

11. Appareillage selon la revendication 9 ou 10, caractérisé en ce qu'il est prévu, à côté de l'élément d'alimentation (72), une ouverture dans le récipient (36) et un élément (66, 66A) permettant une liaison étanche entre la partie en forme de tube et l'ouverture.

12. Appareillage selon l'une quelconque des revendications 9 à 11, caractérisé en ce que l'élément d'alimentation (72) est composé d'une pièce en forme de tube réalisé dans un verre quartzeux ayant le niveau de qualité pour les applications en tant que semi-conducteur.

13. Appareillage selon la revendication 12, caractérisé par un instrument de mesure permettant de visualiser une profondeur de pénétration prédéfinie.

14. Appareillage selon la revendication 13, caractérisé en ce que cet instrument de mesure est une règle graduée (90) fixée sur le récipient (36) et se prolongeant au-dessous du récipient sur une longueur n'atteignant pas l'extrémité de l'élément en forme de tube (72).

15. Appareillage selon la revendication 9, caractérisé en ce que le dispositif d'introduction de masse en fusion (25) dans le récipient (36) est composé d'une source de vide et d'un élément (52, 96) reliant le récipient à la source de vide.

16. Appareillage selon la revendication 15, caractérisé en ce que la source de vide présente un dispositif de maintien de la pression d'air dans le récipient (36).

17. Appareillage selon la revendication 16, caractérisé par un réservoir (100) communiquant avec le récipient (36), ledit réservoir (100) ayant une capacité correspondant environ à 100 fois la capacité du récipient (36).

18. Appareillage selon la revendication 15, caractérisé en ce que le récipient (36) présente une sortie et en ce que l'élément (52,96) est composé d'une tuyauterie flexible reliée au récipient (36) et à la source de vide.

19. Appareillage selon la revendication 18, caractérisé en ce que la tuyauterie flexible consiste en un tube d'acier inox.

20. Appareillage selon la revendication 9, caractérisé en ce que le récipient (36) est composé d'un boîtier (40) et en ce que ledit dispositif (64) d'isolation thermique consiste en l'habillage (74) du boîtier, le matériau d'habillage étant composé d'une couche de garniture compressible qui se comprime dès que la matière initiale se solidifiant dans le réservoir (36) se dilate, protégeant ainsi ledit habillage contre une éventuelle détérioration.
